Europäisches Patentamt

European Patent Office

Office européen des brevets

(19)

(11) Numéro de publication: **0 036 802**
**B1**

(12) **FASCICULE DE BREVET EUROPEEN**

(45) Date de publication du fascicule du brevet:
08.08.84

(51) Int. Cl.³: **H 01 L 45/00**

(21) Numéro de dépôt: **81400378.6**

(22) Date de dépôt: **11.03.81**

(54) **Procédé de réalisation de dispositifs à effet mémoire à semi-conducteurs amorphes.**

(30) Priorité: **24.03.80 FR 8006480**

(43) Date de publication de la demande:
**30.09.81 Bulletin 81/39**

(45) Mention de la délivrance du brevet:
**08.08.84 Bulletin 84/32**

(84) Etats contractants désignés:
**DE GB**

(56) Documents cités:
**FR - A - 2 389 239**
**FR - A - 2 407 572**

**McGraw-Hill Encyclopedia, page 433, Lehrbuch der anorganischen Chemie, p. 862, 867, 882-885 CRC Handbook of Chemistry and Physics, P. B149, B179 and B234**

(73) Titulaire: **COMMISSARIAT A L'ENERGIE ATOMIQUE Etablissement de Caractère Scientifique Technique et Industriel, B.P. 510, F-75752 Paris Cedex 15 (FR)**

(72) Inventeur: **Kumurdjian, Pierre, Baville, F-91530 Saint Cheron (FR)**

(74) Mandataire: **Mongrédien, André et al, c/o BREVATOME 25, rue de Ponthieu, F-75008 Paris (FR)**

## Description

La présente invention concerne un procédé de réalisation de dispositifs à effet mémoire à semiconducteurs amorphes.

De façon plus précise, la présente invention concerne la réalisation de composants à semiconducteurs amorphes utilisés pour la mémorisation électrique.

En général, les dispositifs à semiconducteurs amorphes comprennent un substrat sur lequel est déposée une électrode inférieure, une zone active réalisée à l'aide d'un composé semiconducteur amorphe et une électrode supérieure.

Les différents types de dispositifs à semiconducteurs amorphes, par exemple, de type »pore« ou de type »trois couches« ainsi que les différents procédés permettant de les réaliser, ont été décrits dans le brevet français no 2 365 888 déposé le 28 septembre 1976 au nom du Commissariat à l'Energie Atomique et intitulé »Procédé de réalisation de dispositifs semiconducteurs amorphes et diapositifs en faisant application«, ainsi que dans le certificat d'addition de ce même brevet no 2 389 239 déposé le 27 avril 1977.

De plus, ces différents types de dispositifs à semiconducteurs peuvent présenter un effet de mémorisation ou un effet de commutation suivant leur structure.

Des études ont montré que ces effets dépendent entre autres de la nature de l'électrode. En particulier, un bon effet de commutation peut être obtenu à l'aide d'électrodes réalisées en Carbone. En ce qui concerne les dispositifs à effet mémoire, on utilise actuellement des électrodes réalisées en Molybdène, mais ces électrodes présentent différents inconvénients et notamment une mauvaise aptitude à cet effet mémoire. De plus, ce matériau est difficile à déposer, si l'on désire une couche sans contrainte, sans défaut et non évolutive dans le temps avec les impulsions électriques ou thermiques qui lui sont imposées, lors de l'utilisation d'un tel dispositif. Par ailleurs, ce matériau piège très facilement l'oxygène présent sur le substrat et les différentes couches des autres matériaux constituant le semiconducteur, ce qui impose certaines conditions dans le procédé de dépôt, lors de la réalisation du semiconducteur.

La présente invention a pour but de remédier à ces inconvénients et notamment de permettre la réalisation de dispositifs à semiconducteur dont les électrodes présentent une bonne aptitude à l'effet mémoire et dont le dépôt de ces électrodes est facilement réalisable.

L'invention a pour objet un procédé de réalisation de dispositifs à effet mémoire à semiconducteurs amorphes du type de ceux décrits précédemment et consistant à:

— réaliser la zone active sous la form d'une couche centrale constituant une couche active proprement dite, réalisée en un premier composé semiconducteur amorphe et, d'au moins une couche tampon disposée sur l'une des faces supérieure et inférieure de ladite couche active, lesdites couches tampon étant réalisées à l'aide d'un deuxième composé semiconducteur amorphe, ce composé étant un composé quaternaire de corps choisis dans le groupe comprenant le Germanium, le Tellure, l'Arsenic et le Soufre; et

— réaliser l'une au moins des électrodes sous la forme d'une électrode constituant l'électrode proprement dite et, d'une couche mince tournée vers la zone active constituant une barrière;

ledit procédé se caractérisant en ce que les électrodes proprement dites sont réalisées en Tungstène ou en Tantale, ces métaux pouvant diffuser dans les couches tampon et pouvant former avec le deuxième composé semiconducteur amorphe, constituant lesdites couches tampon, un composé binaire, à structure hexagonale, de manière à former la barrière nécessaire à la stabilisation du semiconducteur.

Selon un mode préférentiel de l'invention, l'une au moins des couches barrières est réalisée en Tellurure de Tantale ou en Tellurure de Tungstène.

Selon un autre mode préférentiel de l'invention, le premier composé amorphe, constituant la couche active proprement dite, est réalisé par du verre de composition $Te_{79}Ge_{17}S_2Sb_2$. Par ailleurs, le deuxième composé semiconducteur amorphe constituant les couches tampon est réalisé par du verre de composition $Te_{60}As_{25}Ge_{13}S_1$.

Selon un autre mode préférentiel de l'invention, on dépose une couche isolante au-dessus de l'une ou l'autre des électrodes proprement dites. Cette couche isolante est de préférence réalisé en Nitrure de Silicium. De plus l'électrode supérieure proprement dite peut être recouverte d'une couche conductrice en Aluminium.

D'autres caractéristiques et avantages de l'invention ressortiront mieux à l'aide de la description qui va suivre, donnée à titre purement illustratif et non limitatif, en référence aux figures annexées dans lesquelles:

— la fig. 1 représente schématiquement les différentes couches de matériaux constituant un dispositif à effet mémoire selon l'invention,

— la fig. 2 représente schématiquement un premier mode de réalisation d'un dispositif à effet mémoire, selon l'invention,

— la fig. 3 représente schématiquement un deuxième mode de réalisation d'un dispositif à effet mémoire, selon l'invention.

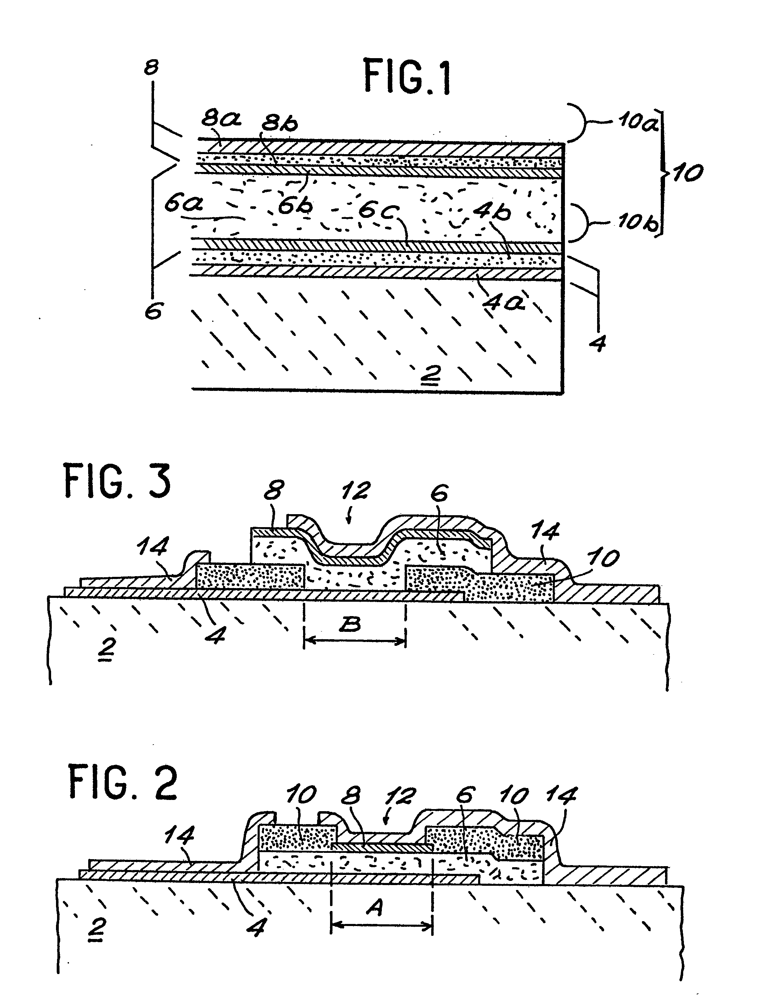

Sur la fig. 1, la référence 2 représente le substrat sur lequel on réalise le dispositif à semiconducteur, la référence 4 représente l'électrode inférieure, la référence 6 représente la zone active réalisée à l'aide d'un composé semiconducteur amorphe et la référence 8 une électrode supérieure. En fait, comme on l'a dit précédemment, les électrodes 4 et 8 ainsi que la zone active 6 présentent une structure plus complexe.

L'électrode inférieure 4 comporte une électrode proprement dite 4a, directement au contact du substrat 2 et une couche mince 4b tournée vers la zone active 6 et constituant une barrière. De même, l'électrode supérieure 8 comporte une électrode proprement dite 8a, et une couche mince 8b constituant une barrière, tournée vers la zone active 6 comme la barrière 4b.

Les électrodes proprement dites 4a et 8a sont réalisées en un métal susceptible de former un composé binaire à structure hexagonale, tel que le Tungstène ou le Tantale. En effet, ces matériaux présentent l'avantage d'être des matériaux aptes à l'effet mémoire. Les barrières 4b oi 8b sont constituées par ledit composé binaire à structure hexagonale. Dans le cas d'électrodes en Tantale, les barrières 4b ou 8b sont réalisées par exemple en Tellurure de Tantale et dans le cas d'électroces en Tungstène, les barrières 4b ou 8b sont réalisées par exemple en Tellurure de Tungstène. Ces barrières 4b et 8b sont nécessaires à la stabilisation du semiconducteur.

De même, la zone active 6 est constituée d'une couche active proprement dite 6a, d'une couche tampon supérieure 6b et d'une couche tampon inférieure 6c. Ces couches tampon 6b et 6c permettent d'éviter toute diffusion de l'électrode dans la zone active 6a. Cette couche active proprement dite 6a est réalisée en un composé riche en Tellure et, de préférence, par du verre de composition $Te_{79}Ge_{17}S_2Sb_2$. De même, les couches tampon 6b et 6c sont réalisées en un composé vitreux de préférence riche en Tellure et présentant la composition $Te_{60}As_{25}Ge_{13}S_1$.

La présence de Tellure dans les couches tampon 6b et 6c permet la formation, par diffusion, des électrodes 4a et 8a dans ces couches tampon, des couches barrières 4b et 8b en un composé binaire à structure hexagonale sous la forme d'un Tellurure de Tantale ou d'un Tellurure de Tungstène, pour des électrodes 4a et 8a réalisées soit en Tantale soit en Tungstène.

De même, avec des couches tampon 6b et 6c réalisées en un composé vitreux riche en Soufre on peut obtenir, par diffussion des électrodes 4a et 8a dans ces couches tampon, des couches barrières 4b et 8b en un composé binaire à structure hexagonale sous la forme d'un Sulfure de Tantale ou d'un Sulfure de Tungstène pour des électrodes 4a et 8a réalisées soit en Tantale soit en Tungstène.

Lors de la réalisation d'un dispositif conforme à l'invention, suivant la nature des électrodes, les électrodes d'un même dispositif pouvant être de nature différente, ainsi que le type de caractéristiques que l'on désire obtenir pour le dispositif à semiconducteur amorphe, on peut déposer une ou deux couches barrière et/ou une ou deux couches tampon. On peut aussi réaliser la couche barrière par diffusion, avant toute utilisation du dispositif à semiconducteur. Dans le cas contraire, dès le début d'utilisation de ce dispositif, la présence d'une couche tampon permet la réalisation de cette couche barrière, par diffusion de l'électrode en métal apte à diffuser dans cette couche tampon.

Sur la fig. 1, la référence 10 correspond à une couche isolante réalisée de préférence en Nitrure de Silicium et pouvant être placée, soit sur une partie de l'électrode supérieure 8, ladite couche étant référencée 10a, soit sur une partie de l'électrode inférieure 4, ladite couche étant alors référencée 10b. La position de cette couche isolante 10 dépend du type de dispositif que l'on réalise.

Le dispositif, selon l'invention, représenté sur la fig. 2, correspond à un dispositif de type »trois couches«. Ce dispositif est obtenu en déposant les trois couches correspondant aux deux électrodes 4 et 8 et à la zone active 6, comme décrites précédemment sur le substrat 2 suivant des techniques connues. Le dépôt étant fait on grave les trois couches 4, 6 et 8 au gabarit de l'électrode inférieure 4, par exemple par érosion mécanique et par voie sèche, puis par le même procédé, l'électrode supérieure 8 de façon à lui donner sa dimension finale.

Dans l'étape suivante, on effectue par tous moyens connus un dépôt uniforme d'un matériau isolant constituant la couche isolante 10. Cette couche isolante 10 peut être constituée par tout composé à l'exclusion d'un oxyde. De préférence, cette couche isolante 10 est réalisée en Nitrure de Silicium.

L'étape suivante consiste à graver la couche isolante 10, par exemple par bombardement d'Argon. On définit également dans cette couche isolante 10 une fenêtre 12 au-dessus de l'électrode supérieure 8.

Dans l'étape suivante, on effectue un dépôt uniforme de matériau conducteur 14, puis on grave ce dépôt pour séparer la conduction de l'électrode inférieure 4 et de l'électrode supérieure 8. La zone active A est ainsi définie par la surface de l'électrode supérieure 8.

Le dispositif selon l'invention représenté sur la fig. 3 correspond à un dispositif de type »pore«. Ce dispositif est obtenu par dépôt de l'électrode inférieure 4 sur le substrat 2, puis par gravure de ce dépôt pour lui donner la forme recherchée. On effectue ensuite un dépôt uniforme de la couche isolante 10 réalisée de préférence en Nitrure de Silicium. On grave ensuite, comme précédemment la couche 10 pour ménager la fenêtre 12 qui définit la zone active B du composant semiconducteur. Ensuite, on dépose la couche active 6, l'électrode supérieure 8, puis la couche conductrice 14. Enfin, on grave la couche conductrice 14 et la couche active 6 pour dégager les plots de connexion électrique.

La couche conductrice 14 est réalisée, par exemple, en Aluminium.

Pour plus amples détails sur le procédé de fabrication d'un dispositif de type »pore« ou de type »trois couches«, on peut se référer aux brevets cités précédemment.

Suivant la nature des électrodes, ainsi que la nature des couches tampon, la composition de la couche barrière sous la forme d'un composé binaire à structure hexagonale peut être différente, par exemple, pour une couche tampon riche en Tellure on obtient un composé du type $WTe_2$ pour une électrode en Tungstène et un composé du type $TaTe_2$ pour une électrode en Tantale; pour une couche tampon riche en Soufre et une électrode en Tantale on obtient un composé du type $TaS_2$ et un composé du type $WS_2$ pour une électrode en Tungstène. L'avantage de tels composés est d'être de très bons ralentisseurs de diffusion du fait même de leur structure.

## Revendications

1. Procédé de réalisation de dispositifs à effet mémoire à semiconducteurs amorphes comprenant, dans l'ordre, un substrat (2) sur lequel est déposée une électrode inférieure (4), une zone active (6) réalisée à l'aide d'un composé semiconducteur amorphe et une électrode supérieure (8), consistant à:

— réaliser la zone active sous la forme d'une couche centrale (6a) constituant une couche active proprement dite, réalisée en un premier composé semiconducteur amorphe et, d'au moins une couche tampon (6b ou 6c) disposée sur l'une des faces supérieure et inférieure de ladite couche active (6a), lesdites couches tampon (6b ou 6c) étant réalisées à l'aide d'un deuxième composé semiconducteur amorphe, ce composé étant un composé quaternaire de corps choisis dans le groupe comprenant le Germanium, le Tellure, l'Arsenic et le Soufre; et
— réaliser l'une au moins des électrodes sous la forme d'une électrode (4a ou 8a) constituant l'électrode proprement dite et d'une couche mince (4b ou 8b) tournée vers la zone active (6) constituant une barrière,

ledit procédé se caractérisant en ce que les électrodes proprement dites (4a et 8a) sont réalisées en Tungstène ou en Tantale, ces métaux pouvant diffuser dans les couches tampon (6b ou 6c) et pouvant former avec le deuxième composé semiconducteur amorphe constituant lesdites couches tampon un composé binaire à structure hexagonale, de manière à former la barrière (4b ou 8b) nécessaire à la stabilisation du semiconducteur.

2. Procédé selon la revendication 1, caractérisé en ce que la barrière (4b ou 8b) est réalisée en Tellurure de Tantale.

3. Procédé selon la revendication 1, caractérisé en ce que la barrière (4b ou 8b) est réalisée en Tellurure de Tungstène.

4. Procédé selon l'une quelconque des revendications 1 à 3, caractérisé en ce que le premier composé amorphe constituant la couche active proprement dite (6a) est réalisé par du verre de composition $Te_{79}Ge_{17}S_2Sb_2$.

5. Procédé selon l'une quelconque des revendications 1 à 4, caractérisé en ce que le deuxième composé semiconducteur amorphe constituant les couches tampon est réalisé par du verre de composition $Te_{60}As_{25}Ge_{13}S_1$.

6. Procédé selon l'une quelconque des revendications 1 à 5, caractérisé en ce que l'on dépose une couche isolante (10) sur l'électrode supérieure propremend dite (8a).

7. Procédé selon l'une quelconque des revendicatons 1 à 5, caractérisé en ce que l'on dépose une couche isolante (10) sur l'électrode inférieure (4).

8. Procédé selon l'une quelconque des revendications 6 et 7, caractérisé en ce que la couche isolante (10) est réalisée en Nitrure de Silicium.

9. Procédé selon l'une quelconque des revendications 1 à 8, caractérisé en ce que l'électrode supérieure proprement dite (8a) est recouverte d'une couche conductrice en Aluminium (14).

## Patentansprüche

1. Verfahren zur Herstellung amorpher Halbleiter-Speicheranordnungen, die der Reihenfolge nach ein Substrat (2), auf dem eine untere Elektrode (4) aufgebracht ist, einen mittels einer amorphen Halbleiterverbindung gebildeten aktiven Bereich (6) und eine obere Elektrode (8) umfassen, wobei der aktive Bereich in der Form einer mittleren Schicht (6a) gebildet wird, welche eine eigentliche aktive Schicht darstellt, die aus einer ersten amorphen Halbleiterverbindung und wenigstens einer Pufferschicht (6b oder 6c) hergestellt ist, die auf der oberen oder unteren Seite der aktiven Schicht (6a) angeordnet ist, wobei die Pufferschichten (6b oder 6c) mittels einer zweiten amorphen Halbleiterverbindung gebildet sind, wobei diese Verbindung eine quatärnere Verbindung von Elementen ist, die aus der Germanium, Tellur, Arsen und Schwefel umfassenden Gruppe ausgewählt sind, und wobei wenigstens eine der Elektroden in der Form einer Elektrode (4a oder 8a), die die eigentliche Elektrode bildet, und einer dünnen Schicht (4b oder 8b) ausgebildet ist, welche zu dem aktiven Bereich (6) gewandt ist und eine Sperre darstellt, dadurch gekennzeichnet, daß die eigentlichen Elektroden (4a und 8a) aus Wolfram oder Tantal hergestellt werden und daß diese Metalle in die Pufferschichten (6b oder 6c) diffundieren und mit der zweiten amorphen Halbleiterverbindung, die die Pufferschichten bildet, eine binäre Verbindung mit hexagonaler Struktur bilden können, derart, daß die zur Stabilisierung des Halbleiters erforderliche Sperre (6b oder 8b) gebildet wird.

2. Verfahren nach Anspruch 1, dadurch gekennzeichnet, daß die Sperre (4b oder 8b) aus Tantaltellurid hergestellt wird.

3. Verfahren nach irgendeinem der Ansprüche 1 bis 2, dadurch gekennzeichnet, daß die Sperre (4b oder 8b) aus Wolframtellurid hergestellt wird.

4. Verfahren nach irgendeinem der Ansprüche 1 bis 3, dadurch gekennzeichnet, daß die erste amorphe Verbindung, die die eigentliche aktive Schicht (6a) bildet, durch Glas der Zusammensetzung $Te_{79}Ge_{17}S_2Sb_2$ hergestellt wird.

5. Verfahren nach irgendeinem der Ansprüche 1 bis 4, dadurch gekennzeichnet, daß die zweite amorphe Halbleiterverbindung, die die Pufferschichten bildet, durch Glas der Zusammensetzung $Te_{60}As_{25}Ge_{13}S_1$ hergestellt wird.

6. Verfahren nach irgendeinem der Ansprüche 1 bis 5, dadurch gekennzeichnet, daß eine isolierende Schicht (10) auf die eigentliche obere Elektrode (8a) aufgebracht wird.

7. Verfahren nach irgendeinem der Ansprüche 1 bis 5, dadurch gekennzeichnet, daß eine isolierende Schicht (10) auf die untere Elektrode (4) aufgebracht wird.

8. Verfahren nach Anspruch 6 oder 7, dadurch gekennzeichnet, daß die isolierende Schicht (10) aus Siliziumnitrid hergestellt wird.

9. Verfahren nach irgendeinem der Ansprüche 1 bis 8, dadurch gekennzeichnet, daß die eigentliche obere Elektrode (8a) mit einer leitenden Schicht aus Aluminium (14) bedeckt ist.

**Claims**

1. Process for the production of amorphous semiconductor memory devoces comprising, in order, a substrate (2) on which are deposited a lower electrode (4), an active zone (6) formed with the aid of an amorphous semiconductor compound, and an upper electrode (8), which comprises:

— producing the active zone in the form of a central layer (6a) constituting an active layer proper, formed from a first amorphous semiconductor compound, and from at least one buffer layer (6b or 6c) on one of the upper or lower surfaces of said active layer (6a), said buffer layers (6b or 6c) being produced with the aid of a second amorphous semiconductor compound, said compound being a quaternary compound of substances selected from the group comprising germanium, tellurium, arsenic and sulphur; and

— producing at least one of the electrodes in the form of an electrode (4a or 8a), constituting the electrode proper, and from a thin layer (4b or 8b) turned towards the active zone (6), constituting a barrier,

said process being characterized in that the electrodes proper (4a and 8a) are formed from tungsten or tantalum, said metals being able to diffuse into the buffer layers (6b or 6c) and being able to form, with the second amorphous semiconductor compound constituting said buffer layers, a binary compound of hexagonal structure, whereby to form the barrier (4b or 8b) necessary for stabilization of the semiconductor.

2. Process according to claim 1, characterized in that the barrier (4b or 8b) is formed from tantalum telluride.

3. Process according to claim 1, characterized in that the barrier (4b or 8b) is formed from tungsten telluride.

4. Process according to any one of claims 1 to 3, characterized in that the first amorphous compound constituting the active layer proper (6a) is formed from a glass having the composition $Te_{79}Ge_{17}S_2Sb_2$.

5. Process according to any one of claims 1 to 4, characterized in that the second amorphous semiconductor compound constituting the buffer layers is formed from a glass having the composition $Te_{60}As_{25}Ge_{13}S_1$.

6. Process according to any one of claims 1 to 5, characterized in that an insulating layer (10) is deposited on the upper electrode proper (8a).

7. Process according to any one of claims 1 to 5, characterized in that an insulating layer (10) is deposited on the lower electrode (4).

8. Process according to either of claims 6 or 7, characterized in that the insulating layer (10) is formed from silicon nitride.

9. Process according to any one of claims 1 to 8, characterized in that the upper electrode proper (8a) is covered with an aluminium conductive layer (14).

# FIG.1

# FIG. 3

# FIG. 2